# EUROPÄISCHE PATENTSCHRIFT

(11) **EP 3 181 284 B1**
(45) Veröffentlichungstag und Bekanntmachung des Hinweises auf die Patenterteilung: **12.09.2018**
(21) Anmeldenummer: 15200687.0
(22) Anmeldetag: 17.12.2015
(51) Int. Cl.: B23K 9/10, B23K 11/24, H01F 38/08, H01L 23/495, H01L 25/07, H02M 7/00

(54) **STROMRICHTERSCHALTUNG**
FREQUENCY CONVERTER
CIRCUIT DE CONVERTISSEUR

(43) Veröffentlichungstag der Anmeldung: 21.06.2017
(73) Patentinhaber: ROBERT BOSCH GMBH, 70442 Stuttgart (DE)
(72) Erfinder: Scholz, Reinhard, 64711 Erbach (DE); Trautmann, Oliver, 64395 Brensbach (DE); Luger, Ludwig, 64720 Michelstadt (DE); Steinbrecher, Michael, 64711 Erbach (DE)
(74) Vertreter: Thürer, Andreas

(56) Entgegenhaltungen:
- EP-A1- 2 717 460
- EP-A2- 2 101 402
- DE-A1-102011 012 199

## Beschreibung

### Technisches Gebiet

Die vorliegende Erfindung betrifft eine Stromrichterschaltungsanordnung zur Bereitstellung eines elektrischen Starkstromes, insbesondere eines elektrischen Stromes, wie er bei industriellen Prozessen oder bei leistungsfähigen Maschinen benötigt wird.

### Stand der Technik

EP 2 717 460 A1 zeigt eine Energiewandlungsvorrichtung mit einer Umrichterschaltung, die einen Gleichstrom in einen Wechselstrom wandelt.

In der EP 1 921 908 B1 ist eine Anordnung zur Bereitstellung eines elektrischen Starkstromes gezeigt. Die Figur 1 verdeutlicht hier schematisch in einer Seitenansicht wie aufwändig es ist die in solchen Anordnungen auftretenden Wärmeverluste abzuführen. Bei komplexeren Schaltungen, bei denen mehrere Leistungshalbleiter zum Einsatz kommen, erhöht sich der Aufwand entsprechend. Neben dem Materialaufwand ist dabei auch noch der Aufwand für die Montage, Wartung und Reparatur zu beachten.

Ein zusätzlicher Nachteil der hier gezeigten Anordnung ist, dass die Wärmeabführung vom Leistungsmodul aus betrachtet lediglich nach unten erfolgt. Außerdem ist die Bauhöhe der Anordnung ungünstig für den Wärmeabtransport ausgestaltet, denn je höher die Schichtdicke, desto schwieriger gestaltet sich die Wärmeabfuhr vom Leistungsmodul. Insgesamt ist die gezeigte Anordnung daher speziell bei der Verwendung hoher Ströme nicht zu empfehlen. Die Verwendung von Druckkontaktierungen ist ebenfalls nachteilig, da diese sehr hohe mechanische Spannkräfte beim Zusammenfügen der Anordnung erfordern, was entsprechende aufwändige mechanische Vorrichtungen erfordert im Umfeld der Anordnung und Bauraum beansprucht. Wünschenswert wäre eine Anordnung, welche bei vergleichbarer Leistung insgesamt kompakter aufgebaut ist, ohne äußere Einspannvorrichtungen auskommt und für Starkströme geeignet ist.

### Offenbarung der Erfindung

Erfindungsgemäß wird eine Stromrichterschaltungsanordnung gemäß des unabhängigen Patentanspruches vorgeschlagen. Vorteilhafte Ausgestaltungen sind Gegenstand der abhängigen Ansprüche sowie der nachfolgenden Beschreibung.

Die Stromrichterschaltungsanordnung ist für einen elektrischen Starkstrom ausgelegt. Unter einem elektrischen Starkstrom wird ein Strom verstanden, wie er beispielsweise beim Widerstandsschweißen, zum Antrieb von Servomotoren, zum Antrieb von leistungsfähigen Maschinen oder beim Antrieb von Elektrofahrzeugen auftritt. Es handelt sich in der Regel um Ströme im einstelligen oder im mehrstelligen Kiloampere-Bereich, vorzugsweise aus Dreiphasen-Netzen. Es kommen insbesondere Anwendungen in Frage, bei denen die Schaltung ausgehend von einer Zwischenkreisspannung mittels eines Wechselrichters gespeist wird. Die Anordnung dient insbesondere zum industriellen Widerstandsschweißen, wo Ströme beispielsweise bis 20 kA oder höher auftreten können.

Bei den ersten und zweiten steuerbaren Schaltmitteln handelt es sich bevorzugt um Leistungshalbleiter. Jeder Leistungshalbleiter umfasst zumindest einen Stromeingang, einen Stromausgang und einen Steueranschluss. Es kann sich beispielsweise um Metall-Oxid-Feldeffekttransistoren und dergleichen handeln, oder auch um IGBTs.

Zur Aufnahme der Leistungshalbleiter ist ein Bauteilträger mit Leiterbahnen vorgesehen. Bei dem Bauteilträger handelt es sich um ein elektrisch isolierendes Material mit leitenden Verbindungen. Als isolierendes Material kann faserverstärkter Kunststoff verwendet werden, insbesondere auch flexible Materialien, insbesondere auch folienartige Materialien. Die Leistungshalbleiter sind vollständig oder teilweise in den Bauteilträger eingebettet, vorzugsweise sind die Leistungshalbleiter allseitig oder abschnittsweise vom Material des Bauteilträgers umgeben. Bei besonders bevorzugter vollständiger Einbettung der Leistungshalbleiter in den Bauteilträger sind diese nicht mehr sichtbar, weil sie sich im Inneren des Bauteilträgers befinden und dort mit zumindest einer Leiterbahnebene verbunden sind.

Die Leistungshalbleiter sind zur Realisierung einer Stromrichterschaltung mittels der Leiterbahnen miteinander verschaltet. Die Stromrichterschaltung kann beispielsweise als Mittelpunktschaltung, Brückenschaltung oder Wechselwegschaltung realisiert sein. Sie ist vorzugsweise zum Wechselrichten oder Gleichrichten oder zum Umrichten vorgesehen. Vorzugsweise wir die Stromrichterschaltung zur Gleichrichtung eines Wechselstromes in einen Gleichstrom vorgesehen.

### Vorteile der Erfindung

Aufgrund des erfindungsgemäßen Aufbaus konnte die während des Betriebs des Stromrichters entstehende Verlustleistung signifikant reduziert werden.

Aufgrund des erfindungsgemäßen Aufbaus erhält man einen kompakten Stromrichter, welcher leicht in ein Gehäuse integriert werden kann und damit im Feld leicht montiert oder ausgewechselt werden kann. Bevorzugt ist das Gehäuse nach Art einer Scheibenzelle realisiert, in welche der Stromrichter vollständig integriert ist. Derartige Scheibenzellen lassen sich leicht handhaben, lagern oder einbauen. Das Gehäuse kann jedoch auch jede andere - dem Anwendungsfall entsprechende Form - erhalten, vorzugsweise wir es flach bauend ausgebildet und mit einer runden oder rechteckigen Form versehen.

Mittels der Einbettung der Leistungshalbleiter und/oder der Leiterbahnen in den Bauteilträger konnten die während des Betriebs durch die Verlustwärme entstehenden thermischen Verformungen der Bauteile und/oder des Bauteilträgers ausgeglichen und vermindert werden. Dementsprechend geringer sind die mechanischen Belastungen, denen die gesamte Anordnung während des Betriebs ausgesetzt ist. Als Leistungshalbleiter wird bevorzugt ein Halbleiter mit separatem Gehäuse verwendet, vorzugsweise mit einem CAN-Gehäuse.

Der erfindungsgemäße Stromrichter kann daher mit weniger aufwändigen mechanischen Konstruktionen zum Einspannen oder Arretieren des Stromrichters an seinem Einsatzort angeordnet werden und ersetzt Stromrichterschaltungen basierend auf Einzelbauteilen, wie beispielsweise Gleichrichterdioden, welche in der Regel mit einer hohen Verlustleistung einhergehen und deren Montageaufwand wegen erforderlicher komplizierter mechanischer Druckkontakttechnik hoch ist und viel Raum beansprucht.

Vorzugsweise umfasst der Bauteilträger mehrere übereinander angeordnete Bauteilträgerebenen oder Leiterbahnebenen. Der Bauteilträger kann zu diesem Zwecke mehrlagig ausgebildet sein, d.h. er kann mehrere Leiterbahnebenen umfassen, welche mittels Durchkontaktierungen miteinander verbunden sein können. Bevorzugt sind die Stromeingänge mit einer ersten Ebene und die Stromausgänge mit einer zweiten Ebene verbunden. Die Steuereingänge können mit einer dritten Ebene verbunden sein, wobei die dritte Ebene vorzugsweise zwischen der ersten und der zweiten Ebene angeordnet ist. Jeder Steuereingang kann auch mit einer eigenen Leiterbahnebene verbunden sein, welche vorzugsweise zwischen der ersten und der zweiten Ebene angeordnet sind. Prinzipiell können jedoch auch andere Verbindungen realisierbar sein. So können zum Beispiel die Steuereingänge mit einer ersten oder zweiten Ebene und die Stromeingänge/Stromausgänge bzw. Leistungshalbleiteranschlüsse mit den jeweils anderen Ebenen verbunden sein. Es können auch mehr oder weniger als drei Ebenen vorgesehen sein.

Die Materialdicke des Bauteilträgers ist derart ausgelegt, dass diese bei noch ausreichender Stabilität den geringstmöglichen thermischen Widerstand hat. Hierdurch wird der Bauteilträger auch mechanisch leicht flexibel, speichert Wärme kaum und kann aufgrund von Wärmeentwicklungen auftretende mechanische Spannungen kompensieren.

Vorteilhafterweise sind die Steueranschlüsse derart angeordnet, dass Steuerleitungen für die Leistungshalbleiter zur Ansteuerung der Steueranschlüsse am Bauteilträger im Wesentlichen gleichartig bzw. symmetrisch zueinander sind. Dies gilt insbesondere zumindest hinsichtlich der Leiterbahnführung, der Leiterbahnabmessungen und der Leiterbahnformem. Für eine optimale Anpassung, beispielsweise eines Schweißstroms, an eine spezielle Schweißaufgabe, kann ein Stromanstieg zu Schweißbeginn oder auch ein Stromabfall am Ende der Schweißaufgabe programmiert werden. Hierzu ist ein schnelles Schalten des Stromes erforderlich, damit die Schweißstromimpulse möglichst wie vorgegeben umgesetzt werden können. Mittels des erfindungsgemäßen Vorschlags bezüglich der Steuerleitungen kann ein schnelles Schalten der Leistungshalbleiter mittels der optimierten Leiterbahnführung gewährleistet werden.

Vorzugsweise sind von dem Stromrichter Mittel zum eingangsseitigen Anschluss der Stromrichterschaltung an Transformatorwicklungen und zum ausgangsseitigen Anschluss der Stromrichterschaltung an eine Last umfasst. Damit kann der Stromrichter leicht beispielsweise in eine vorhandene Applikation integriert werden, wie beispielsweise eine Widerstandsschweißanwendung.

Vorzugsweis ist die Stromrichterschaltung als Mittelpunktschaltung realisiert. So kann eine Last ausgangsseitig auch an die Mittelanzapfung einer Transformatorwicklung sekundärseitig angeschlossen werden. Man kommt dann mit nur zwei Leistungshalbleitern aus.

Besonders bevorzug ist eine Ansteuereinrichtung zur Ansteuerung der der Leistungshalbleiter in den Bauteilträger zumindest teilweise eingebettet oder auf dem Bauteilträger angeordnet und mittels der Leiterbahnen mit den Steueranschlüssen verbunden sowie insbesondere zwischen den Stromleitplatten (mechanischer Schutz) angeordnet. Die Ansteuereinrichtung generiert Ansteuerimpulse, mittels welcher die Leistungshalbleiter durchschaltbar sind. Die Ansteuereinrichtung kann auch noch komplexere Aufgaben übernehmen, wie beispielsweise eine Zustandsüberwachung des Stromrichters. Vorzugsweise ist von dem Bauteilträger eine Datenschnittstelle umfasst (z.B. Feldbusschnittstelle oder Funkschnittstelle), so besteht zusätzlich die Möglichkeit, dass die Ansteuereinrichtung mit einer übergeordneten Einrichtung kommunizieren und Instruktionen für die Ansteuerung erhalten kann. Beim Widerstandsschweißen beispielsweise erfolgt das Schweißen mittels Impulsen. Zur Realisierung einer Vorwärmzeit oder Nachwärmzeit mit einem entsprechenden Stromwert und zur Realisierung der Schweißimpulse beispielsweise könnte die Ansteuereinrichtung somit autark oder im Zusammenspiel mit einer übergeordneten Schweißsteuerung die Ansteuerung der Leistungshalbleiter übernehmen. Für eine optimale Anpassung zum Beispiel eines Schweißstroms an eine spezielle Schweißaufgabe, kann ein Stromanstieg zu Schweißbeginn oder auch ein Stromabfall am Ende der Schweißaufgabe programmiert werden. Die gesamte Schweißzeit kann über die Eingabe der Impulsanzahl somit mehrfach von der Ansteuereinrichtung wiederholt werden.

Bevorzugt ist der Bauteilträger zwischen zumindest einer elektrisch leitfähigen Stromeingangsplatte (erste oder zweite Stromleitplatte) und zumindest einer elektrisch leitfähigen Stromabgangsplatte (zweite oder erste Stromleitplatte) angeordnet und im Wesentlichen parallel zu beiden Stromleitplatten ausgerichtet. Die Stromeingänge beider Leistungshalbleiter sind bevorzugt mit der Stromeingangsplatte bzw. die Stromausgänge beider Leistungshalbleiter sind bevorzugt mit der Stromabgangsplatte elektrisch leitend verbunden. Bevorzugt sind entweder die Stromeingänge beider Leistungshalbleiter mit jeweils einer gemeinsamen oder separaten Stromeingangsplatte und/oder die Stromausgänge beider Leistungshalbleiter mit jeweils einer gemeinsamen oder separaten Stromabgangsplatte elektrisch leitend verbunden. Hierdurch lässt sich das zuvor erwähnte Scheibenzellengehäuse oder ein dazu sehr ähnliches flaches Gehäuse leicht realisieren.

Vorteil der Anordnung ist, dass mittels beider Stromleitplatten eine Wärmeableitung und gleichzeitig eine Stromleitung realisiert ist. Stromeingangsplatte und Stromabgangsplatte erfüllen daher eine Doppelfunktion, nämlich einerseits die Stromzuführung und Stromableitung zum/vom Leistungshalbleiter und aufgrund der sandwichförmigen Anordnung gleichzeitig auch die Kühlung des Halbleiters stromeingangsseitig und/oder stromausgangsseitig. Die hinsichtlich der Bauhöhe optimierte Anordnung bedingt kurze Wege für Strom und Wärme. Daraus resultieren geringe Verluste innerhalb der Anordnung selbst und ein schneller Wärmeabtransport. Temperaturabfälle im Material treten kaum auf.

Der erfindungsgemäße Aufbau der Anordnung ist vorzugsweise vergossen, was auch einen mechanischen Zusammenhalt der Komponenten sicherstellt, und somit keine Druckkontaktierungen erfordert. Die mit Druckkontaktierungen verbundenen Nachteile wären damit überwunden. Gegenüberliegend zueinander angeordnete Stromeingänge und/oder Stromausgänge vereinfachen den Einbau des erfindungsgemäßen Leistungsbauteils in entsprechende Bauteilhalterungen, wie sie beispielsweise für Scheibenzellen verwendet werden. Als Plattenmaterial kommt beispielsweise Kupfer oder Molybdän in Frage. Die zuvor erwähnten Verbindungen zwischen Leistungshalbleiter und Platten können mittels Löten und/oder Sintern und/oder mittels mechanischer Verbindungselemente realisiert werden.

Es wird vorgeschlagen, an zumindest einer Stromleitplatte geeignete Mittel vorzusehen, so dass Wärme von der Stromleitplatte leicht abführbar ist. Dies ist beispielsweise mittels Stromleitplatte mit integrierten Kühlkanälen zur Realisierung einer Wasserkühlung während des Betriebs der Anordnung realisierbar. Es könnten jedoch auch zusätzliche separate Kühlplatten mit Kühlkanälen zu den Stromleitplatten verwendet werden, welche an der Stromeingangsplatte und/oder der Stromabgangsplatte bevorzugt anliegen. Diese zusätzlichen Kühlplatten könnten auch Bestandteil einer Halterung für die Stromrichterschaltungsanordnung sein, wobei die Anordnung zwischen beiden Kühlplatten einklemmbar ist, so dass ein optimaler Wärmeübergang und Stromübergang zwischen allen Platten und den Anschlüssen der Halterung gewährleistet ist.

Bevorzugt sind die Platten (Kühlplatten und/oder Stromleitplatten) in ihrem Randbereich mittels eines elektrisch nicht leitfähigen Verbindungsmittels miteinander verbunden, wobei Platten und Verbindungsmittel ein Gehäuse bilden. Als Verbindungsmittel kommen Vergussmassen, wie beispielsweise Harze, in Frage. Materialien aus Hartkunststoff oder Weichkunststoff kommen ebenfalls in Frage. Es ist vorgesehen, dass der Steueranschluss weiterhin zugänglich bleibt.

Idealerweise wird mittels des Stromrichters ein Gleichrichter für eine Schweißvorrichtung realisiert. Der Stromrichter übernimmt dabei die Funktion einer bekannten Widerstandsschweißdiode. Ein Schweißtransformator bildet bevorzugt mit einem zuvor genannten Gleichrichter eine bauliche Einheit. Eine Schweißvorrichtung für Widerstandsschweißen mit einem entsprechenden Transformator ist somit leicht realisierbar.

Insgesamt bewirkt die Erfindung eine höhere Leistungsdichte bei stark reduzierten Wärmeverlusten, geringeren Baugrößen und stark vermindertem Gewicht durch den Wegfall schwerer und unförmiger mechanischer Klemmeinrichtungen.

Es versteht sich, dass die vorstehend genannten und die nachfolgend noch zu erläuternden Merkmale nicht nur in der jeweils angegebenen Kombination, sondern auch in anderen, hier nicht explizit genannten Kombinationen, oder in Alleinstellung oder isoliert auftreten können, ohne den Rahmen der vorliegenden Erfindung zu verlassen.

Die Erfindung ist anhand von Ausführungsbeispielen in den nachfolgenden Zeichnungen schematisch dargestellt und wird im Folgenden unter Bezugnahme auf die Zeichnungen ausführlich beschrieben. In den Figuren sind gleiche oder funktionsgleiche Merkmale mit denselben Bezugszeichen versehen, sofern nichts anderes angegeben ist.

### Figurenbeschreibung

Figur 1 zeigt grob schematisch eine Mittelpunktschaltung als eine bevorzugte Ausführungsform;
Figur 2 zeigt grob schematisch eine erste bevorzugte Bauform;
Figur 3 zeigt grob schematisch eine Halbbrücke als eine bevorzugte Schaltung.

### Detaillierte Figurenbeschreibung

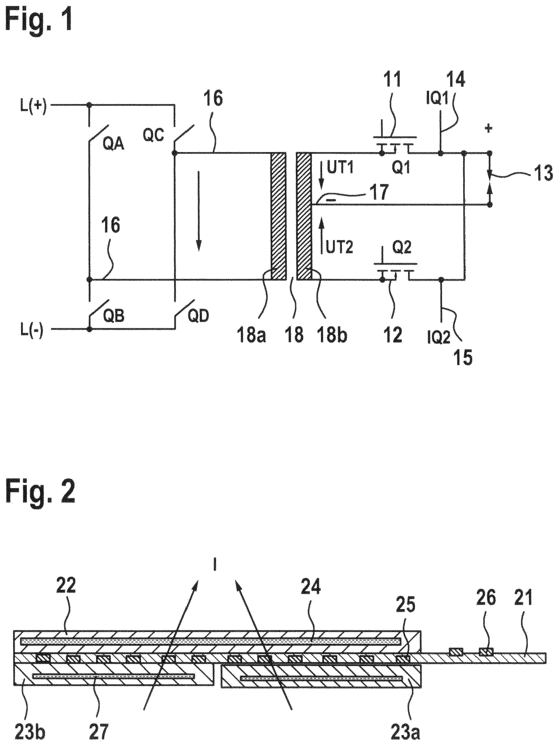

In Figur 1 ist eine Mittelpunktschaltung gezeigt. Links im Bild ist eine Vollbrücke dargestellt. Diese umfasst einen ersten und einen zweiten Brückenarm. Beide Brückenarme liegen parallel an einer (Zwischen-) Gleichspannung L(+) und L(-). Jeder der Brückenarme umfasst zwei Schalter QA, QB und QC, QD beispielsweise in Form von IGBTs. Das Schalterpaar QA, QB ist dem ersten Brückenarm und das Schalterpaar QC, QD ist dem zweiten Brückenarm zugeordnet. Im Brückenzweig ist die Primärwicklung 18a eines Schweißtransformators 18 angeordnet.

Rechts im Bild ist der erfindungsgemäße Stromrichter gezeigt. Dieser ist angeordnet an zwei Sekundärwicklungen 18b des Schweißtransformators 18. Beide Sekundärwicklungen 18b sind in Serie geschaltet und bilden am Kontaktpunkt der Serienschaltung eine Mittelanzapfung 17. Somit entsteht ein erster Sekundärzweig und ein zweiter Sekundärzweig. An der Mittelanzapfung 17 ist eine erste Schweißelektrode 13 einer elektrischen Widerstandsschweißzange angeschlossen, welche während des Schweißvorganges sowohl ein positives als auch negatives Potential aufweisen kann. Eine zweite Schweißelektrode 13 ist mit den Leistungshalbleitern 11 (Q1) und 12 (Q2) verbunden. Der erste Leistungshalbleiter 11 ist im ersten Sekundärzweig und der zweite Leistungshalbleiter 12 ist im zweiten Sekundärzweig angeordnet. In jedem der Zweige ist eine Strommessvorrichtung 14, 15 für die die Zweigströme IQ1, IQ2 vorgesehen. Die Bauteile der in Figur 1 gezeigten Schaltungsanordnung, insbesondere Q1 und Q2, und vorzugsweise auch die Strommessvorrichtungen 14, 15, sowie die Verbindungsleitungen zwischen den Bauteilen sind in einen Bauteilträger (nicht gezeigt, siehe Figur 2, Bezugszeichen 21) zumindest teilweise und vorzugsweise vollständig eingebettet.

Die sekundärseitigen Leistungshalbleiter 11, 12 dienen zur Beaufschlagung eines Werkstückes mit Schweißstrom mittels der Schweißelektroden 13. Die Leistungshalbleiter 11, 12 sind vorzugsweise mit Freilaufdioden als Überspannungsschutz (nicht gezeigt) ausgestattet. Die Freilaufdioden können auch in die Leistungshalbleiter 11, 12 integriert sein.

Am Schweißtransformator 18 wird bevorzugt ein Magnetfeldsensor (nicht gezeigt) angeordnet. Die Signale des Magnetfeldsensors werden bevorzugt von der Ansteuervorrichtung (nicht gezeigt, siehe Figur 2, Bezugszeichen 26) ausgewertet, so dass die Leistungshalbleiter 11, 12 auch unter Verwendung des Auswerteergebnisses des Sensorsignales geschaltet werden können. Mittels des Magnetfeldsensors kann Einfluss auf die Systemperformance genommen werden.

Die Leistungshalbleiter 11, 12 sind vorzugsweise symmetrisch auf dem Bauteilträger angeordnet. Diese symmetrische Ausbildung ermöglicht eine gleichförmige Stromverteilung, was sich vorteilhaft auf die Systemperformance auswirkt.

Figur 2 zeigt eine erste bevorzugte Ausführungsform für die bauliche Umsetzung des Stromrichters in Sandwich-Bauweise. Gezeigt sind mehrere in eine Leiterplatte 21 eingebettete Leistungshalbleiter 25, welche, wie in Figur 1 gezeigt (siehe Bezugszeichen 11 und 12), miteinander verschaltet sind. Die in Figur 1 gezeigten Leistungshalbleiter 11 und 12 werden hier im Beispiel jeweils mittels zweier Leistungshalbleitergruppen 11 und 12 realisiert, wobei jede Leistungshalbleitergruppe 11, 12 mehrere parallel zueinander betriebene Einzel-Leistungshalbleiter umfasst, deren Anzahl theoretisch beliebig sein kann und vom bereitzustellenden Strom abhängt. Die hier im Bild dargestellte Anzahl der verwendeten Leistungshalbleiter 25 ist daher nur beispielhaft zu sehen. Jede Leistungshalbleitergruppe 11 und 12 umfasst vorzugsweise n Leistungshalbleiter, wobei n eine positive ganze Zahl außer Null sein kann.

Als elektrisch leitfähige Stromeingangsplatte 23a, 23b sind zwei Kupferplatten 23a, 23b vorgesehen und als elektrisch leitfähige Stromabgangsplatte 22 ist ebenfalls eine Kupferplatte 22 vorgesehen, vorzugsweise mit integrierten Kühlmaßnahmen 24, 27, wie beispielsweise einem Kühlkanal, durch den während des Betriebs ein Kühlmittel, wie Wasser, zugeführt und abgeführt werden kann. Alternativ käme als Material auch Molybdän für die Platten 22, 23a, 23b in Frage.

Die Materialstärke (Dicke) der Platten 23a/b, 22 kann beispielsweise im Millimeterbereich liegen (z.B. 2 mm). Ein Stromanschluss (z.B. Source oder Drain) derjenigen Leistungshalbleiter 25, welche Q1 aus Figur 1 repräsentieren (z.B. MOSFET) ist bevorzugt mit der Stromeingangsplatte 23a und ein Stromanschluss (z.B. Drain oder Source) derjenigen Halbleiter 25, welche Q 2 aus Figur 1 repräsentieren, ist bevorzugt mit der Stromeingangsplatte 23b verbunden. Beide Kupferplatten 23a, 23b sind bevorzugt elektrisch isoliert nebeneinander und parallel zur gegenüberliegenden Stromausgangsplatte 22 ausgerichtet. Weitere Stromanschlüsse (z.B. Drain oder Source) derjenigen Leistungshalbleiter 25, welche Q1 und Q2 repräsentieren, sind bevorzugt mittels der einstückigen Stromabgangsplatte 24 miteinander verbunden. Die Stromeingangsplatte 23a und die Stromeingangsplatte 23b ist bevorzugt zum Anschluss des erfindungsgemäßen Gleichrichters an die Sekundärwicklung 18b (Figur 1) ausgebildet.

Je nach gewünschter Anwendung sind auch alternative Schaltungsanordnungen dazu denkbar (nicht gezeigt). Alternativ ist der Stromanschluss (z.B. Drain oder Source) derjenigen Halbleiter 25, welche Q1 aus Figur 1 repräsentieren (z.B. MOSFET) mit einer ersten Stromausgangsplatte (nicht gezeigt) und der Stromanschluss (z.B. Drain oder Source) derjenigen Halbleiters 25, welche Q2 aus Figur 1 repräsentieren, mit einer zweiten Stromausgangsplatte (nicht gezeigt) verbunden. Beide Stromausgangsplatten (nicht gezeigt) sind dann isoliert nebeneinander und parallel zu einer einzigen gegenüberliegenden Stromeingangsplatte (nicht gezeigt) ausgerichtet. Die Stromanschlüsse (z.B. Source oder Drain) derjenigen Leistungshalbleiter 25, welche Q1 und Q2 repräsentieren, sind bei dieser alternativen Lösung mittels der einteiligen Stromeingangsplatte miteinander verbunden.

In einer weiter bevorzugten Ausführungsform ist sowohl die Stromeingangsplatte, als auch die Stromausgangsplatte mehrteilig ausgebildet und parallel und gegenüberliegend zueinander angeordnet, um Leistungshalbleiter zu umschließen, deren Eingänge und/oder Ausgänge schaltungstechnisch nicht miteinander verbunden sind und mittels frei zugänglicher Steueranschlüsse zwischen beiden Platten ansteuerbar sind.

Die parallel und in ihrem Randbereich bündig zueinander angeordneten Kupferplatten 23a,b und 22 sind mindestens in ihrem Randbereich mittels eines elektrisch nicht leitfähigen Verbindungsmittels (nicht gezeigt) miteinander verbunden, so dass die Kupferplatten 23a,b und 22 zusammen mit dem Verbindungsmittel ein Gehäuse bilden. Das Verbindungsmittel kann eine Vergussmasse sein, es kann alternativ jedoch auch mittels eines Kunststoffes wie Hartkunststoff oder Weichkunststoff realisiert sein. Mittels des Verbindungsmittels kann je nach Anwendung ein Gehäuse realisiert werden, welches auch einer IP-Schutzart genügt.

Es können am Rand beider Kupferplatten 23a,b und 22 zur Anbringung des Verbindungsmittels in sich formschlüssig eingreifende Kontaktierungsmittel vorgesehen sein, welche eine feste Kontaktierung zwischen Verbindungsmittel und Kupferplatten 23a,b und 22 gewährleisten.

Die Stärke der Leiterplatte 21 kann im Mikrometerbereich liegen, beispielsweise 100 Mikrometer. Die Steueranschlüsse der Leistungshalbleiter 25 sind ebenfalls von der Leiterplatte 21 umfasst und können mittels einer ebenfalls von der Leiterplatte 21 umfassten oder in die Leiterplatte integrierten Ansteuereinrichtung 26 für die Leistungshalbleiter 11, 12 verbunden sein.

Wie im Bild gezeigt, kann der eingeprägte Strom (I, Pfeilrichtung maßgeblich) mittels der Steueranschlüsse gesteuert werden und eine vorgebbare Richtung von den Stromeingangsplatten 23a, 23b zur Stromausgangsplatte 22 einnehmen. Die während des Betriebs der Anordnung auftretende Abwärme (Verlustwärme) kann gleichzeitig in beiden Richtungen mittels der Stromeingangsplatten 23a, 23b und der Stromabgangsplatte 22 abgeführt werden, insbesondere beschleunigt, falls Kühlkanäle 23, 27 in allen Platten 22, 23a, 23b vorgesehen sind oder ein Kühlkanal 23, 27 in zumindest einer der Platten 22, 23a, 23b vorgesehen ist.

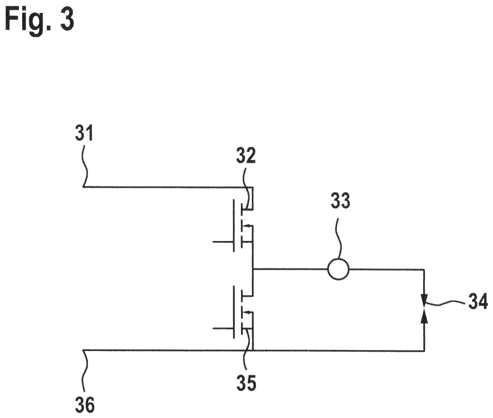

In Figur 3 ist eine eingebettete Halbbrückenschaltung schematisch gezeigt. Die Brücke liegt zwischen einem ersten 31 und einem zweiten 36 Potential und ist mittels zweier MOS-FET Schalter 32, 35 realisiert, deren Steueranschlüsse (offen gezeigt) von der Ansteuereinrichtung 26 (siehe Figur 2) ansteuerbar sind. Eine erste Elektrode einer Schweißzange 34 ist elektrisch zwischen beiden MOS-FET Schaltern 32, 35 angeschlossen. Eine zweite Elektrode der Schweißzange ist in diesem Beispiel mit dem Potential 36 verbunden. Beide Potentiale 31, 36 werden bevorzugt von den in Figur 1 gezeigten Sekundärwicklungen bereitgestellt.

### Bezugszeichenliste

- 11,12: Leistungsschalter, MOSFETs ausgangsseitig
- 13: Last, Schweißzange
- 14, 15: Strommessschaltung
- 16: Primärseitige Transformatoranbindung
- 17: Mittelabzapfung Transformator
- 18: Transformator
- 18a: Primärwicklung Transformator
- 18b: Sekundärwicklung Transformator
- QA,QB,QC, QD -: Leistungsschalter, MOSFETs eingangsseitig
- IQ1, IQ2: Schweißstrom
- L(+), L(-): Zwischenkreisgleichspannung vom Schweißumrichter

- 21: Leiterplatte
- 22: Stromeingangsplatte, Kupferplatte
- 23a, 23b: Stromausgangsplatte(n), Kupferplatte(n)
- 24: Integrierte Wasserkühlung
- 25: Embedded Halbleiter in der Leiterplatte, Stromrichterschaltung
- 26: Ansteuermittel für Steueranschlüsse der Leistungsschalter
- 27: Integrierte Wasserkühlung
- I: Schweißstrom

- 31,36: Spannungsversorgung
- 32, 35: Steuermittel
- 33: Messmittel für Strom
- 34: Schweißzange

## Patentansprüche

1. Stromrichterschaltungsanordnung für einen elektrischen Starkstrom (I), insbesondere zum industriellen Widerstandsschweißen, mit einem Bauteilträger (21) und mit einem ersten und zweiten steuerbaren Schaltmittel (11, 12, 25) für Starkstrom (I) mit jeweils einem eigenen Steueranschluss, wobei die Schaltmittel (11, 12, 25) in den Bauteilträger (21), zumindest teilweise, bevorzugt vollständig, eingebettet sind, wobei der Bauteilträger (21) zwischen einer elektrisch leitfähigen ersten Stromleitplatte (22) und einer elektrisch leitfähigen zweiten Stromleitplatte (23a, 23b) im Wesentlichen parallel zu beiden Stromleitplatten (22, 23a, 23b) angeordnet ist, wobei beide Schaltmittel (11, 12, 25) derart zu einer Stromrichterschaltung miteinander verschaltet und mit den Stromleitplatten (22, 23a, 23b) verbunden sind, dass ein Ausgang der Stromrichterschaltung mittels der ersten oder der zweiten Stromleitplatte (22, 23a, 23b) und ein Eingang der Stromrichterschaltung mittels der zweiten oder der ersten Stromleitplatte (23a, 23b, 22) realisiert ist, wobei es sich bei dem Bauteilträger (21) um ein elektrisch isolierendes Material bzw. Leiterplatte (21) mit Leiterbahnen als leitende Verbindungen für die Schaltmittel (11, 12, 25) handelt, **dadurch gekennzeichnet dass**
die erste und zweite Stromleitplatte (22, 23a, 23b) zusammen mit einem elektrisch nicht leitfähigen Verbindungsmittel in ihrem Randbereich ein Gehäuse nach Art einer Scheibenzelle für die Stromrichterschaltungsanordnung bilden.

2. Anordnung gemäß Anspruch 1, wobei der Bauteilträger (21) mehrere Leitungsebenen umfasst, wobei vorzugsweise der Eingang der Stromrichterschaltung mit einer ersten Leitungsebene und der Ausgang der Stromrichterschaltung mit einer zweiten, von der ersten Leitungsebene getrennten, Leitungsebene verbunden ist, und wobei die Steueranschlüsse mit zumindest einer weiteren Leitungsebene verbunden sind, welche vorzugsweise zwischen der ersten und der zweiten Leitungsebene angeordnet ist, so dass die Steueranschlüsse, bevorzugt getrennt voneinander, mittels der weiteren Leitungsebene ansteuerbar sind.

3. Anordnung gemäß einem der vorhergehenden Ansprüche, wobei zur Ansteuerung der Steueranschlüsse am Bauteilträger (21) im Wesentlichen gleichartig, vorzugsweise symmetrisch zueinander, angeordnete Steuerleitungen vorgesehen sind.

4. Anordnung gemäß einem der vorhergehenden Ansprüche, wobei mechanische Kontaktmittel zum eingangsseitigen Anschluss an eine Transformatorwicklung (18b) und zum ausgangsseitigen Anschluss an eine Last (13) umfasst sind.

5. Anordnung gemäß Anspruch 4, wobei die Stromrichterschaltung als Mittelpunktschaltung realisiert ist und zusätzliche mechanische Kontaktmittel vorgesehen sind, so dass die Last (13) ausgangsseitig zusätzlich auch an eine Mittelanzapfung (17) der Transformatorwicklung anschließbar ist.

6. Anordnung gemäß einem der vorhergehenden Ansprüche, wobei zusätzlich eine Ansteuereinrichtung (26) zur Ansteuerung beider Steueranschlüsse in den Bauteilträger (21) zumindest teilweise, vorzugsweise vollständig, eingebettet ist, und mittels eingebetteter Leiterbahnen mit den Steuerleitungen verbunden sind.

7. Anordnung gemäß einem der vorhergehenden Ansprüche, wobei für jedes Schaltmittel (11, 12, 25) eine Laststrom-Messschaltung (14, 15) vorgesehen ist und vorzugsweise in den Bauteilträger (21) zumindest teilweise, vorzugsweise vollständig, eingebettet ist.

8. Anordnung gemäß Anspruch 7, wobei entweder die erste und/oder die zweite Stromleitplatte (22, 23a, 23b), vorzugsweise die eingangsseitige Stromleitplatte (22, 23a, 23b) mehrteilig ausgebildet ist, vorzugsweise zweiteilig, wobei an das erste Teil der Stromleitplatte (22, 23a, 23b) das erste Schaltmittel (11, 12, 25) und an das zweite Teil der Stromleitplatte (22, 23a, 23b) das zweite Schaltmittel (11, 12, 25) elektrisch angebunden ist.

9. Transformator zum Widerstandsschweißen, insbesondere Mittelfrequenz-Transformator (18, 18a, 18b), mit einer Anordnung gemäß einem der vorhergehenden Ansprüche, wobei die Stromrichterschaltung eingangsseitig an die Sekundärwicklung (18b) des Transformators angeschlossen und am Transformator angeordnet ist.

10. Widerstandsschweißeinrichtung mit einer Vollbrücke (QA, QB, QC, QD), welche an eine Zwischenkreisgleichspannung (L+, L-) angebunden ist, und wobei am Ausgang (16) der Vollbrücke (QA, QB, QC, QD) ein Transformator (18) gemäß Anspruch 9 primärseitig angeschlossen ist, wobei die Stromrichterschaltung ausgangsseitig an Schweißelektroden (13) angebunden ist, welche von einer Schweißzange gehalten sind.

## Claims

1. Current converter circuit arrangement for a high electric current (I), in particular for industrial resistance welding, having a component carrier (21) and having a first and second controllable switching means (11, 12, 25) for high current (I) having in each case a separate control connection, wherein the switching means (11, 12, 25) are embedded at least partly, preferably completely, into the component carrier (21), wherein the component carrier (21) is arranged between an electrically conductive first current conducting plate (22) and an electrically conductive second current conducting plate (23a, 23b) and substantially in parallel with the two current conducting plates (22, 23a, 23b), wherein the two switching means (11, 12, 25) are interconnected with one another to form a current converter circuit and are connected to the current conducting plates (22, 23a, 23b) in such a way that an output of the current converter circuit is realized by means of the first or the second current conducting plate (22, 23a, 23b) and an input of the current converter circuit is realized by means of the second or the first current conducting plate (23a, 23b, 22), wherein the component carrier (21) is an electrically insulating material or printed circuit board (21) having conductor tracks as conductive connections for the switching means (11, 12, 25), **characterized in that** the first and second current conducting plate (22, 23a, 23b),together with an electrically non-conductive connecting means in the edge region thereof, form a housing in the manner of a disc cell for the current converter circuit arrangement.

2. Arrangement according to Claim 1, wherein the component carrier (21) comprises a plurality of conduction planes, wherein the input of the current converter circuit is preferably connected to a first conduction plane and the output of the current converter circuit is preferably connected to a second conduction plane that is isolated from the first conduction plane, and wherein the control connections are connected to at least one further conduction plane, which is preferably arranged between the first and the second conduction plane so that the control connections can be actuated by means of the further conduction plane, preferably separately from one another.

3. Arrangement according to either of the preceding claims, wherein control lines that are arranged on the component carrier (21) in a substantially identical manner, preferably symmetrically to one another, are provided for actuating the control connections.

4. Arrangement according to one of the preceding claims, wherein mechanical contact means for input-side connection to a transformer winding (18b) and for output-side connection to a load (13) are included.

5. Arrangement according to Claim 4, wherein the current converter circuit is realized as a centre-tap circuit and additional mechanical contact means are provided so that the load (13) can also be connected additionally on the output side to a centre tap (17) of the transformer winding.

6. Arrangement according to one of the preceding claims, wherein an actuating device (26) for actuating the two control connections is additionally embedded at least partly, preferably completely, into the component carrier (21), and is connected to the control lines by means of embedded conductor tracks.

7. Arrangement according to one of the preceding claims, wherein a load-current measuring circuit (14, 15) is provided for each switching means (11, 12, 25) and is preferably embedded at least partly, preferably completely, into the component carrier (21).

8. Arrangement according to Claim 7, wherein either the first and/or the second current conducting plate (22, 23a, 23b), preferably the input-side current conducting plate (22, 23a, 23b), is of multipart design, preferably of two-part design, wherein the first switching means (11, 12, 25) is electrically connected to the first part of the current conducting plate (22, 23a, 23b) and the second switching means (11, 12, 25) is electrically connected to the second part of the current conducting plate (22, 23a, 23b).

9. Transformer for resistance welding, in particular medium-frequency transformer (18, 18a, 18b), having an arrangement according to one of the preceding claims, wherein the current converter circuit is connected on the input side to the secondary winding (18b) of the transformer and is arranged on the transformer.

10. Resistance welding device having a full-bridge (QA, QB, QC, QD), which is connected to an intermediate circuit DC voltage (L+, L-), and wherein a transformer (18) according to Claim 9 is connected on the primary side to the output (16) of the full-bridge (QA, QB, QC, QD), wherein the current converter circuit is connected on the output side to welding electrodes (13), which are held by welding tongs.

## Revendications

1. Agencement de circuit de convertisseur pour un courant électrique fort (I), notamment pour le soudage industriel par résistance, doté d'un support de composants (21) et de premier et deuxième moyens de commutation (11, 12, 25) pouvant être commandés pour du courant fort (I), dotés chacun d'une propre borne de commande, les moyens de commutation (11, 12, 25) étant incorporés au moins partiellement, de préférence totalement, dans le support de composants (21), le support de composants (21) étant placé entre une première plaque conductive (22), conductrice d'électricité et une deuxième plaque conductive (23a, 23b), conductrice d'électricité sensiblement à la parallèle des deux plaques conductives (22, 23a, 23b), les deux moyens de commutation (11, 12, 25) étant interconnectés en un circuit de convertisseur et connectés sur les plaques conductives (22, 23a, 23b), de telle sorte qu'une sortie du circuit de convertisseur soit réalisée au moyen de la première ou de la deuxième plaque conductive (22, 23a, 23b) et qu'une entrée du circuit de convertisseur soit réalisée au moyen de la deuxième ou de la première plaque conductive (23a, 23b, 22), le support de composants (21) étant une matière isolante électrique ou carte de circuits imprimés (21) dotée de pistes conductrices en tant que connexions conductrices pour les moyens de commutation (11, 12, 25), **caractérisé en ce que**, dans leur zone marginale, les première et deuxième plaques conductives (22, 23a, 23b) forment en commun avec un moyen de liaison non conducteur d'électricité un boîtier à la manière d'un boîtier circulaire pour l'agencement de circuit de convertisseur.

2. Agencement selon la revendication 1, le support de composants (21) comprenant plusieurs niveaux conducteurs, de préférence l'entrée du circuit de convertisseur étant connectée sur un premier niveau conducteur et la sortie du circuit de convertisseur étant connectée sur un deuxième niveau conducteur, séparé du premier niveau conducteur et les bornes de commande étant connectées sur au moins un niveau conducteur supplémentaire, lequel est placé de préférence entre les premier et deuxième niveaux conducteurs, de sorte que les bornes de commande soient activables de préférence séparément l'une de l'autre, à l'aide du niveau conducteur supplémentaire.

3. Agencement selon l'une quelconque des revendications précédentes, des câbles de commande de type sensiblement identique, placés symétriquement les uns par rapport aux autres, étant prévus pour activer les bornes de commande sur le support de composants (21).

4. Agencement selon l'une quelconque des revendications précédentes, des moyens de contact mécanique étant compris pour la connexion du côté entrée sur un enroulement de transformateur (18b) et pour la connexion du côté sortie sur une charge (13) .

5. Agencement selon la revendication 4, le circuit de convertisseur étant réalisé sous la forme d'une connexion centrale et des moyens de contact mécanique supplémentaires étant prévus de sorte que, du côté sortie, la charge (13) puisse être connectée en supplément sur une prise centrale (17) de l'enroulement de transformateur.

6. Agencement selon l'une quelconque des revendications précédentes, un système d'activation (26) destiné à activer les deux bornes de commande étant incorporé en supplément au moins partiellement, de préférence totalement dans le support de composants (21) et étant connecté sur les câbles de commande au moyen de pistes conductrices incorporées.

7. Agencement selon l'une quelconque des revendications précédentes, un circuit de mesure du courant de charge (14, 15) étant prévu pour chaque moyen de commutation (11, 12, 25) et étant incorporé au moins partiellement, de préférence totalement dans le support de composants (21).

8. Agencement selon la revendication 7, soit la première et/ou la deuxième plaque conductive (22, 23a, 23b), de préférence la plaque conductive (22, 23a, 23b) du côté entrée, étant réalisée en plusieurs parties, de préférence en deux parties, sur la première partie de la plaque conductive (22, 23a, 23b) étant électriquement raccordé le premier moyen de commutation (11, 12, 25) et sur la deuxième partie de la plaque conductive (22, 23a, 23b) étant électriquement raccordé le deuxième moyen de commutation (11, 12, 25).

9. Transformateur pour le soudage par résistance, notamment transformateur à moyenne fréquence (18, 18a, 18b), doté d'un agencement selon l'une quelconque des revendications précédentes, le circuit de convertisseur étant connecté du côté entrée sur l'enroulement secondaire (18b) du transformateur et étant placé sur le transformateur.

10. Système de soudage par résistance avec un pont intégral (QA, QB, QC, QD), lequel est raccordé sur une tension continue intermédiaire (L+, L-) et sur la sortie (16) du pont intégral (QA, QB, QC, QD) étant raccordé du côté primaire un transformateur (18) selon la revendication 9, le circuit de convertisseur étant raccordé du côté sortie sur des électrodes de soudage (13), lesquelles sont maintenues sur une pince de soudage.
